# EUROPEAN PATENT SPECIFICATION

(11) **EP 4 184 567 B1**
(45) Date of publication and mention of the grant of the patent: **28.01.2026**
(21) Application number: 21209050.0
(22) Date of filing: 18.11.2021
(51) Int. Cl.: H01L 23/473

(54) **COOLER UNIT, SEMICONDUCTOR DEVICE AND METHOD FOR MANUFACTURING A COOLER UNIT**
KÜHLEINHEIT, HALBLEITERBAUELEMENT UND HERSTELLUNGSVERFAHREN EINER SOLCHEN KÜHLEINHEIT
UNITÉ DE REFROIDISSEUR, DISPOSITIF SEMI-CONDUCTEUR ET PROCÉDÉ DE FABRICATION D'UNE UNITÉ DE REFROIDISSEUR

(43) Date of publication of application: 24.05.2023
(73) Proprietor: Hitachi Energy Ltd, 8050 Zürich (CH)
(72) Inventor: Fischer, Fabian, 5400 Baden (CH); Santolaria, Lluis, 4600 Olten (CH)
(74) Representative: Epping - Hermann - Fischer

(56) References cited:
- EP-A1- 3 703 117
- DE-A1- 102019 202 903
- JP-A- 2021 086 906

## Description

The present disclosure is related to a cooler unit for a power module and a method for manufacturing a cooler unit for a power module. The present disclosure is further related to a corresponding semiconductor device.

Power modules are used in automotive inverters for example and require a cooler to dissipate heat during operation. Such coolers are fixed to the power modules and may require additional components to set up a stable connection and tight and reliable sealing. The documents DE 102019202903 A1, EP 3703117 A1 and JP 2021 86906 A disclose examples of cooling units for liquid cooling of a power module.

There is a need to provide a cooler that enables a stable coupling to a power module and contributes to reliable and effective heat dissipation during operation of the power module.

Embodiments of the disclosure relate to a cooler unit for liquid cooling of a power module which enable secure coupling and contribute to reliable heat dissipation. Embodiments of the disclosure also relate to a corresponding manufacturing method for such a cooler unit and a corresponding semiconductor device.

According to an embodiment, a cooler unit for liquid cooling of a power module comprises at least one insert and a housing. The at least one insert comprises an upper part and a lower part and is configured to be coupled to the power module with its upper part. The housing provides an internal flow channel for a coolant and comprises at least one recess which penetrates a wall of the housing up to the flow channel. The at least one recess is configured in coordination with the at least one insert geometrically such that a shape and/or an extension like a respective height, a respective width and/or a respective length of the insert and the recess are matched to each other in part at least. The at least one insert comprises copper and is arranged inside the recess and laser welded to the housing such that during operation the coolant flows through the flow channel and around the lower part of the at least one insert. The at least one insert and the housing each comprise a respective welding area. The welding area of the insert is formed at an edge or peripheral region, for example on a topside, a bottom side and/or a sidewall at the edge of the insert. The welding area of the housing is formed at an edge or peripheral region of the housing limiting the at least one recess, which may additionally form a support surface for the insert. The edges relate to respective peripheral regions of the corresponding inserts or housing. Thus, a welding joint is formed by means of laser welding in the welding areas at a sidewall of the insert in part at least. The welding joint formed by means of laser welding can additionally be formed on the topside and/or the bottom side and/or the sidewall circumferentially or perimetrically in part at least. The upper part of the insert comprises a topside with a given surface structure including at least one of recessed portions and elevated parts facing away from the flow channel that is configured to provide predetermined coupling properties for coupling the cooler unit to the power module.

By use of the described configuration a cooler unit is feasible that enables a secure coupling to a power module and further contributes to reliable heat dissipation during operation of the power module. Inter alia, the cooler unit is suitable for power modules for use in high voltage applications, for example for a voltage of at least 0.5 kV.

The cooler unit is specially configured connectable to intended power modules with its upper part or its topside of the upper part facing the power module. In that the cooler unit comprises copper it allows for sufficient heat dissipation. Thus, the copper of the insert may be available in sections of the cooler unit. In this respect, the insert can be made of copper entirely or in sections, wherein the insert can comprise copper in form of bare copper and/or copper alloy. Due to the laser welded copper insert a stable and secure connection to the housing is set up and because of its thermal conductivity the copper insert enables beneficial heat dissipation.

The upper part and the lower part denote sections or portions of the insert which can also be referred to first and second section or portion. The upper part and the lower part can realize two separate elements coupled together or two portions of a common single element like a copper plate. Thus, the upper part and the lower part can denote portions of the insert formed in one piece. The upper part and the lower part can comprise the same shape and the same geometrical extension or they can differ from each other. In the latter, the upper part may form a plate-like portion whereas the lower part may form a thicker cuboid or block-shaped portion, for example. Moreover, the upper part and/or the lower part can comprise flat surfaces and/or structured surfaces in part or completely.

Moreover, it is also possible to couple an insert to the housing not comprising copper necessarily. The insert can realize an inlay comprising a material and/or a shape that provides a higher thermal conductivity than the housing of the cooler unit to reliably dissipate heat from the power module.

According to a further embodiment, the housing comprises aluminum. In this respect, the housing can be made of aluminum entirely or in sections, wherein the housing can comprise aluminum in form of bare aluminum and/or aluminum alloy. Alternatively or additionally, the housing can comprise copper as well.

Depending on specifications with respect to weight, costs, material properties, it is also possible, that alternatively the housing is made of copper or copper alloy entirely. According to such a configuration there is no need for a welding joint and the housing and the at least one insert can be made in one piece, wherein the at least one insert would realize a corresponding at least one connecting area on a topside of the housing for coupling to a power module.

According to the aforementioned embodiment, the copper insert is laser welded to the aluminum housing and is securely connected inside the recess provided for it. The at least one recess of the housing forms a cavity or an opening that is covered by the at least one insert. The insert is inserted in the cavity or placed in the opening from above and laser welded at its contacting edge, for example, and forms a closed cooler apart from an inlet and an outlet for the coolant. Thus, in a section the insert forms a copper cover on the topside of the housing. In view of an assembled or mounted state, the power module is connected to the topside of the insert, for example by means of gluing, soldering, sintering and/or diffusion bonding.

It is a recognition in connection with the present disclosure that conventional coolers are mechanically fixed to power modules using a clamping mechanism. Such a conventional configuration is comparably complicated including screwed clamps and needs an additional sealing like an O-ring. Especially the use of rubber seals, threaded connections may result in loss of torque and consequently in loss of reliability due to thermal cycling and thus in the risk of loss of coolant due to leakage in long-term operation.

Due to the described structure of the copper insert that is laser welded to the housing there is no need for additional sealing elements. Moreover, laser welding enables a secure connection of the insert to the housing and does not require a bonding agent or welding coating. Thus, the described configuration can be securely and reliably assembled to form the cooler unit.

It is a further recognition in connection with the present disclosure that a conventional welding process has a strong thermal impact on the joining partners. Here the thermal impact on an assembled power module having plastic parts like a molded package body can be seen as very critical. Due to the precisely localized laser welding the thermal impact of the welding process is clearly limited and the welding process can be performed reliably without or with reduced endangering adjacent components. Depending on the setup of the power module, the power module can be mounted to the insert after laser welding of the insert and the insert can realize a stand-alone element forming a part of the cooler unit and/or forming a part of the power module, e.g. a baseplate at a bottom of the power module.

According to a further embodiment, the at least one insert comprises at least one coating that partially or completely covers at least one of the upper part and the lower part of the insert. For instances, the at least one coating comprises nickel and covers the lower part of the insert. The nickel coating can be configured to protect the insert from corrosion due to its contact to the coolant during operation. However, the nickel coating can be used for other purposes as well. Alternatively or additionally, the at least one coating comprises silver and/or gold and covers the upper part of the insert configured to provide predetermined coupling properties for coupling the cooler unit to the power module. Alternatively or additionally, there can be formed a coating in one or both welding areas of the housing and the insert to improve the formation of the welding joint and the coupling of the insert to the housing. Thus, the insert can be completely uncoated or completely or partially coated. The coating on the topside and/or the coating on the underside can be prepared from nickel, silver, gold and/or other materials suitable to provide protection and/or connection properties and may be form electroless or by means of a galvanic process or other applicable processes.

According to a further embodiment, the lower part of the insert comprises an underside with a given surface structure facing the flow channel. Thus, the lower part may form a given cooling structure to provide extensive heat exchange surface between the insert and the coolant. The lower part of the insert is in contact with the coolant partially at least when the coolant flows through the flow channel. A shape and/or orientation of the given surface structure can be configured to provide laminar flow or preferably turbulent flow of the coolant in part at least. The surface structure at the underside of the lower part can therefore be designed to beneficially influence the streaming behavior of the flowing coolant. In this respect pressure drop and flow rate of the coolant can also be taken into account in view of forming the given surface structure. The surface structure can be realized by a pin-fin area using pins having cylindrical or conical shape, for example to increase the overall thermal efficiency provided with the increased surface area to effectively transfer heat to the coolant. Additionally or alternatively, the surface structure can comprise ribs and/or a skived structure and/or meander channels. Alternatively, the lower part of the insert can be formed without a specific structure on its underside and thus may comprise a flat surface. According to an embodiment, the insert may realize a simple copper plate with flat surfaces at its topside and/or bottom side. Cooling structures such as pins or skived fins can be incorporated in a heatsink to which the flat lower part of the insert can be attached.

The given surface structure on the topside comprises recessed portions and/or elevated parts and can additionally comprise a rough surface. The one or more recessed portions or elevated parts are for improving joining processes and reliability of joining connections to the power module. The given surface can completely cover the topside or may be limited to an area of joining connection with power module.

According to a further embodiment, the housing comprises an inlet and an outlet defining a flow direction of the coolant during operation. The housing further comprises two or more recesses configured to accommodate respective two or more inserts, wherein the at least one insert comprising copper is arranged in one of the recesses that is closer to the outlet than the inlet of the housing. Due to cost reduction, the cooler unit may comprise one or more inserts made of aluminum. Thus, the aluminum inserts can be used for thermally non-critical power modules, e.g. closer to the coolant inlet, whereas the one or more copper inserts are needed for thermally more critical power modules, e.g. closer to coolant outlet, because of the higher thermal conductivity of copper in comparison with aluminum. Alternatively or additionally, different cooling properties may be achieved also by different cooling structures of respective lower parts of the inserts.

There also might be a situation of power modules with different properties so that the most critical power module would be mounted to the copper insert, but not mounted closer to the outlet necessarily. In addition, it could be the case that an inlet temperature is reduced or low and coolant thermal properties are worse. In such a case, it is possible that a temperature of chips of a first power module is higher than of a temperature of a last power module with respect to a streaming direction of the coolant. In these cases, it might be also preferred to have a copper insert closer to the inlet than the outlet of the housing. Thus, the position of the one or more copper inserts should be taken into account with respect to the specific situation in view of an improved heat dissipation.

According to a further embodiment, the cooler unit comprises three inserts each comprising copper and the housing comprises three recesses each penetrating the wall of the housing up to the flow channel. The recesses each are configured in coordination with the associated insert geometrically, and the inserts are arranged inside the respective associated recess and each are laser welded to the housing.

According to an embodiment, a semiconductor device, comprises an embodiment of the described cooler unit and a power module with electronics that is coupled to the upper part of the insert of the cooler unit. The electronics may include chips, integrated circuits and/or other discrete devices, especially power semiconductor devices. Chips or other devices are typically mounted, e.g. to an isolating substrate, an (insulated metal) baseplate, a PCB, or a leadframe. The devices can be encapsulated to a module housing or an encapsulation. A backside of the substrate, baseplate, etc. is typically exposed for mounting to the insert. Thus, the insert can form a component of the described cooler unit. Alternatively, the insert can form a component of the power module serving as a baseplate. Thus, the power module can comprise its own baseplate and/or the insert serves as a (additional) baseplate. However, when the power module is fixed to the housing the insert is coupled to the housing as well and thus the described cooler unit is formed.

According to a further embodiment, the topside at the upper part of the insert and the power module are coupled with each other by means of at least one of gluing, sintering, soldering and bonding or other applicable joining methods.

According to an embodiment, a method for manufacturing an embodiment of the described cooler unit comprises providing the at least one copper insert and providing the housing with the at least one recess. The method further comprises placing the at least one insert inside the recess such that the at least one insert contacts the housing, for example with a circumferential edge. The at least one insert is arranged inside the recess such that the lower part faces the flow channel inside the housing. The method further comprises laser welding the at least one insert and the housing together such that during operation the coolant flows through the flow channel and around the lower part of the at least one insert.

As a result of that the described semiconductor device and the described manufacturing method comprise or are related to produce an embodiment of the cooler unit, described features and characteristics of the cooler unit are also disclosed with respect to the semiconductor device and the manufacturing method and vice versa.

The described cooler unit for liquid cooling is suitable for power semiconductor modules without pin-fin baseplate without reduction or very little reduction of the thermal performance or even with an improvement of the thermal performance compared with conventional modules. This also allows for a thinner baseplate of a power module to be assembled. The power module may have a baseplate with a flat back side, or the power module may even have no baseplate like a molded power package with an exposed back side of the substrate, heat sink, or die pad of the lead frame, or a printed circuit board.

By use of copper inserts welded to the housing the thermal resistance can be reduced about 10% or more compared to aluminum inserts. An even better thermal performance of the setup can be achieved, if the inserts of the cooler unit act as a pin-fin baseplate made of copper due to the clearly higher thermal conductivity and the higher mechanical strength of copper allowing a thinner baseplate and potentially reducing the thermal resistance depending on the respective setup. The inserts or baseplates are joined to the housing which realizes a cooler frame made of aluminum, for example. The joining is performed by laser welding between the aluminum housing and the copper insert(s). It is a further recognition in connection with the present disclosure that welded joining of a bare copper or copper alloy insert is less critical with respect to thermal impact, so that the laser welding process can be applied at best.

The inserts define the positions the power modules are connected to the cooler unit. The described embodiments of the cooler unit enable one or more of the following benefits when using an aluminum housing with copper inserts or baseplates being joined to the housing by laser welding:
- The thermal performance of the setup using at least one copper insert, which may serve as a power module baseplate, is improved compared with the use of an aluminum insert due to the higher thermal conductivity of copper.
- A thinner baseplate or insert can be prepared compared with an aluminum insert, but also compared with a pin-fin baseplate of a power module:
   o Copper provides a better mechanical stability compared with aluminum
   o Warpage of the power module baseplate in the assembly process of the power module, which requires a sufficient thickness of the baseplate, is less relevant or must even not be considered
- The realization of a complete cooler unit made of copper would be expensive and would have a large weight but is possible as well. In order to keep costs down only the relevant part of the cooler unit can be made of copper or cooper alloy.
- An assembly of a power module with a flat baseplate or no baseplate is less cost-effective and less complicated
- A direct bonding (sintering, soldering, gluing, diffusion bonding) of a (molded) power module is feasible having no baseplate, but an exposed backside of a substrate, heat sink, or die pad is possible without any additional coating of the top surface of the copper insert (as it is needed for an aluminum insert, for instances).

Exemplary embodiments are explained in the following with the aid of schematic drawings and reference numbers. The figures show:
- Figures 1-5: an embodiment of a cooler unit for power modules in different views;
- Figure 6: an embodiment of an insert of the cooler unit according to the figures 1-5 in a perspective view;
- Figure 7: a molded power package and the cooler unit according to the figures 1-5 in a side view; and
- Figure 8: a flow chart for a method for manufacturing an embodiment of the cooler unit.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in the figures, the description thereof is not repeated for each of the following figures. For the sake of clarity elements might not appear with corresponding reference symbols in all figures possibly.

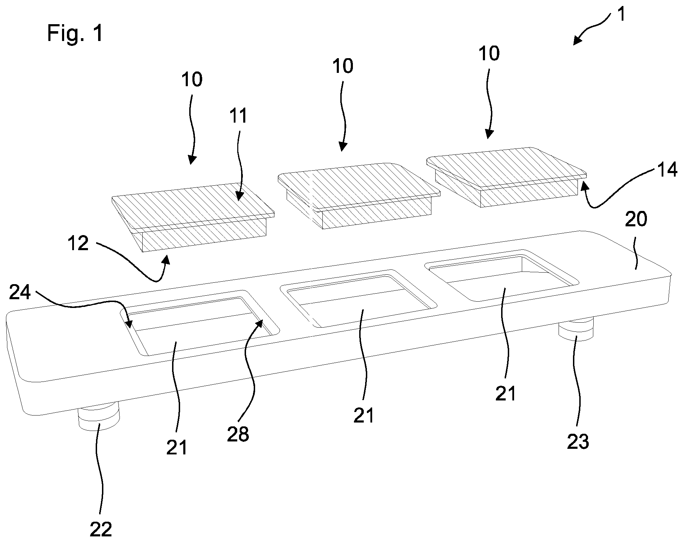

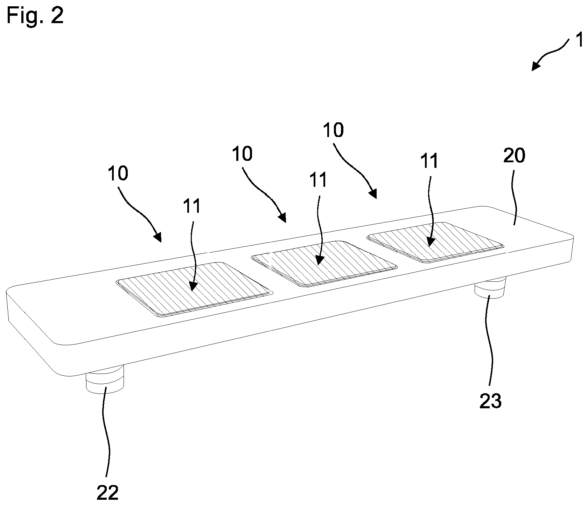

Figure 1 illustrates a perspective view of an embodiment of a cooler unit 1 for liquid cooling of a molded power package or power module 30 (see also Figs. 2-7). The cooler unit 1 comprises three inserts 10 that each comprise an upper part 15 and a lower part 16, respectively. The inserts 10 are configured to be coupled to the power module 30 or to more power modules 30 with their respective upper parts 15.

The cooler unit 1 further comprises a housing 20 that provides an internal flow channel 27 for a coolant. The housing further comprises an inlet 22 and an outlet 23 for the coolant so that during operation the coolant can flow through the housing 20. The housing 20 further comprises three recesses which penetrates a wall of the housing 20 up to the flow channel 27. The wall belongs to an upper part 25 of the housing 20 which is connected with a lower part 26 of the housing 20. Thus, the housing 20 can be assembled from two parts, for example. Alternatively, the housing 20 can be made in one piece. According to the illustrated embodiment the inlet 22 and the outlet 23 belong to the lower part 26 of the housing 20. The recesses 21 are configured in coordination with the inserts 10 geometrically, wherein the inserts 10 comprise copper or copper alloy. Alternatively, at least one of the inserts 10 comprises copper or copper alloy.

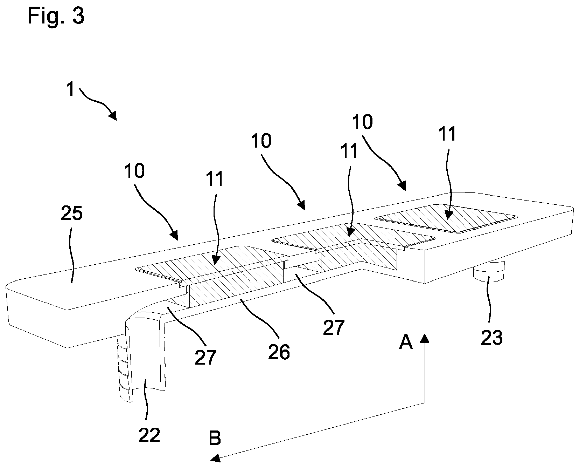

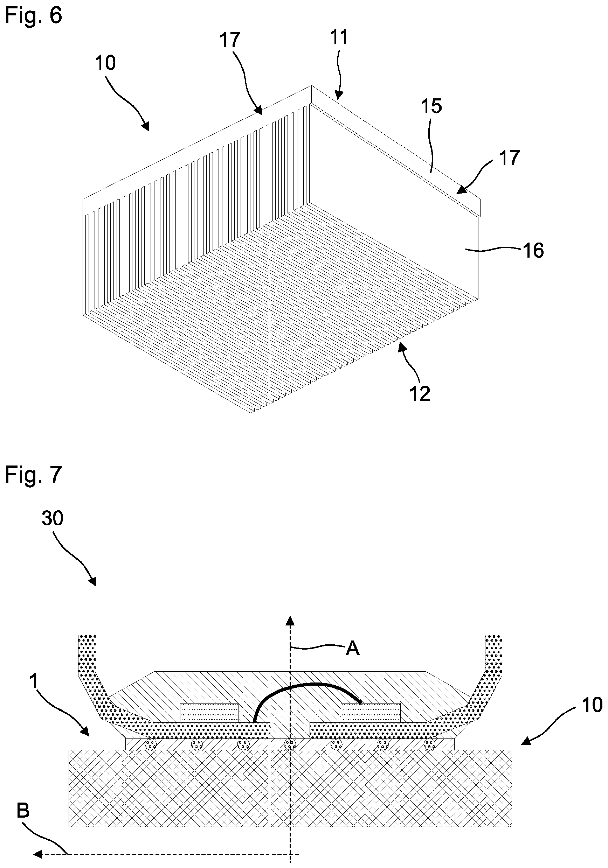

The upper parts 15, 25 and the lower parts 16, 26 of the inserts 10 and the housing 20 respectively denote sections or portions in view of a stacking direction A (see Figs. 3 and 7). These parts can also be referred to first and second section or portion. The upper part 15, 25 and the lower part 16, 26 can realize two separate elements coupled together or two portions of a common single element formed in one piece.

The inserts 10 are configured to be arranged inside the associated recesses 21 and laser welded to the housing 20 such that during operation the coolant flows through the inlet 22 into the housing 20, through the flow channel 27 and around the lower parts 16 of the inserts 10, and through the outlet 23 out of the housing 20. The figures 2 to 5 show further views of the cooler unit 1 or sections thereof.

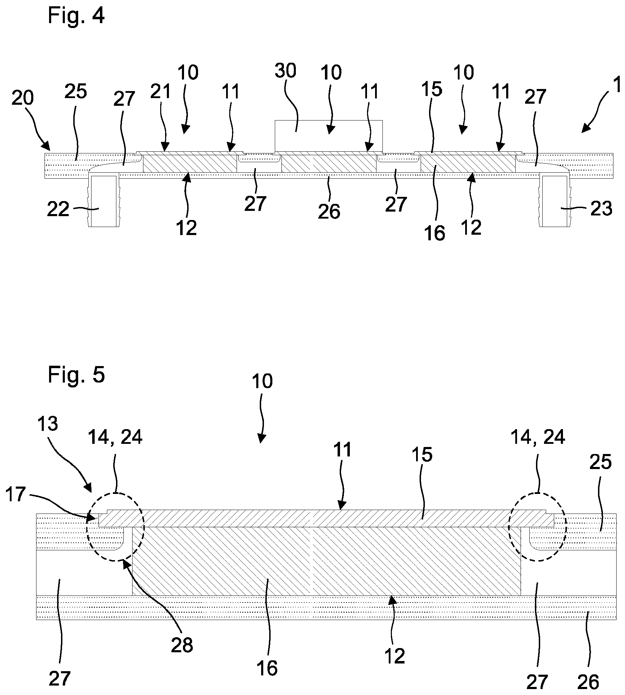

The housing 20 comprises aluminum is laser welded with the cooper inserts 10. Therefore, the inserts 10 and the housing 20 comprise a respective welding area 14, 24 the laser welding joint is to be formed. The welding area 14 of the insert 10 is formed at an edge 13 of the insert 10 and may be formed circumferentially (see also Fig. 5). The edge 13 may be formed as a step edge realizing a circumferential or perimetral sidewall 17 of the upper part 15 of the associated insert 10. The step edge 13 comprises a thinned outermost part that contributes to a reliable laser welding due to reduced amount of laser energy needed in the thinned section.

Thus, a topside 11 of the respective insert 10 may be formed with a protrusion or protruding region with respect to the outermost edge and may realize a portion of the upper part 15 which is configured to be connected to the associated power module 30. There can also be formed structures in the welding area 14 at the edge 13 for improvement of the laser welding process, if the laser irradiation is coming from top. Such surface structures may also comprise a rough surface, a recessed portion and/or a protruding part for improved mounting of power module 30.

Respective welding areas 24 of the housing 20 are formed at edges 28 of the housing 20 that limit the respective recesses 21. The edges 28 can also be formed as circumferentially and may further realize a support surface for the respective edge 13 of the associated insert 10 (see Fig. 5). Thus, a welding joint is formed by means of laser welding in the welding areas 14, 24 circumferentially or in part at least to connect firmly the copper inserts 10 to the aluminum housing 20. In figure 5 a cross section view is illustrated wherein arrows indicate possible positions for formation of the laser welding joints. Thus, by means of laser welding a corresponding welding joint can be formed at the sidewall 17 and/or at a bottom side of edge 13 the insert 10.

The housing 20 may be formed locally thinned and/or may comprise structures useful for welding like a groove, a recess or a dip in the welding areas 24 which contribute to a beneficial formation of a laser welding joint. Such structures can be formed on the top, the side and/or the bottom of the upper part 25 of the housing 20 to guide the laser energy to a predetermined position in the welding areas 14, 24. Thus, the laser welding can be done from the topside and/or from the bottom side with respect to the stacking direction A (see Figs. 3 and 7). Thus, the terms "upper", "lower", "top", "bottom", "side" are used to refer to positions and/or orientations as illustrated in the figures and with respect to the drawn in stacking direction A.

The inserts 10 and/or the housing 20 can comprise the above described welding structures. The inserts 10 may be welded to the housing 20 from the top, from the side and/or from the bottom. In the latter, the inserts 10 are laser welded to the upper part 25 of the housing 20 beforehand the housing 20 is assembled, hence beforehand the lower part 26 of the housing 20 is connected to the upper part 25.

The inserts 10 can have a shape of a baseplate and can protrude above the topside of upper part of the housing 20 with respect to the stacking direction A perpendicular to a lateral direction B (see Figs. 3-5 and 7). A part of the inserts 10 may be made of aluminum, especially closer to coolant inlet 22. The inserts 10 can comprise a coating that partially or completely covers the respective upper part 15 and/or the respective lower part 16. Such a coating may comprise nickel and may be formed to cover the respective lower part 16 which is in contact with the coolant during operation to protect the insert 10 from corrosion.

Additionally or alternatively, a coating may comprise silver and may be formed to cover the upper part 15 or the topside 11 of the insert 10 to provide improved coupling properties for coupling the cooler unit 1 to the associated power module 30. The power module 30 or power package is mounted on top of the insert 10 by gluing, sintering, soldering, diffusion bonding, or any other applicable joining method. A backside of the power module 30 to be joined is provided by a baseplate or by the exposed back side of a substrate, die pad, heat sink, or by a printed circuit board, for example. In figure 7 an embodiment of the power module 30 fixed to the cooler unit 1 at its bottom side is schematically illustrated in a cross section side view.

The lower part 16 of the insert 10 can comprise an underside 12 with a given surface structure facing the flow channel 27 in order to form a cooling structure and to provide turbulent flow of the coolant, preferably. The lower part 16 of the insert 10 is in contact with the coolant partially at least during operation of the connected power module 30 when the coolant flows through the flow channel 27 to dissipate heat from the inserts 10. The surface structure at the underside 12 of the lower part 16 can therefore be designed to beneficially influence the streaming behavior of the flowing coolant. The surface structure can be realized by a pin-fin area using pins having cylindrical or conical shape, for example. Additionally or alternatively, the surface structure can comprise ribs and/or a skived structure. Such a skived structure at the underside 12 of the insert 10 is illustrated in figure 6.

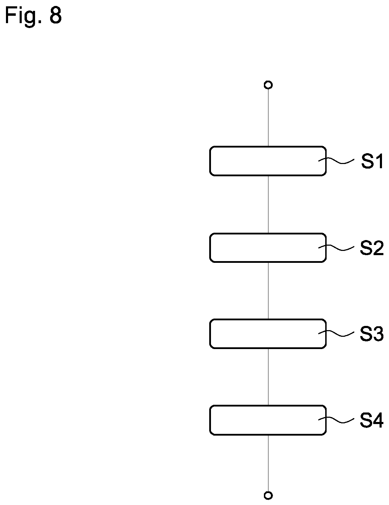

Steps of a corresponding manufacturing method to form the cooler unit 1 can follow the flow chart as shown in Figure 8. In a step S1 the copper inserts 10 are provided, comprising a given surface structure on the topside 11 and/or the underside 12 possibly.

In a step S2 the aluminum housing 20 is provided, comprising predetermined structures in the welding areas 24 at the edges 28 possibly.

In a step S3 the inserts 10 are placed inside the associated recesses 21 such that the inserts 10 contacts the housing 20 in the region of the circumferential edges 13 and 28. The inserts 10 are arranged inside the recesses 21 such that the respective lower parts 16 face the flow channel 27 inside the housing 20.

In a further step S4 the welding process is performed by means of laser welding in the welding areas 14, 24 to firmly connect the inserts 10 with the housing 20. Thus, during operation the coolant can flow through the flow channel 27 and around the lower parts 16 of the inserts 10 to dissipate heat away from the power module 30. Thus, a closed cooler with a laser welded copper baseplate is feasible.

The embodiments shown in or described by the figures 1 to 8 as stated represent exemplary embodiments of the improved cooler unit 1 and the manufacturing method for; therefore, they do not constitute a complete list of all embodiments. Actual arrangements and methods may vary from the embodiments shown in terms of cooler units, for example.

### Reference signs

- 1: cooler unit
- 10: insert of the cooler unit
- 11: topside of the insert
- 12: underside of the insert
- 13: edge of the insert
- 14: welding area of the insert
- 15: upper part of the insert
- 16: lower part of the insert
- 17: sidewall of the edge
- 20: housing of the cooler unit
- 21: recess of the housing
- 22: inlet of the housing
- 23: outlet of the housing
- 24: welding area of the housing
- 25: upper part of the housing
- 26: lower part of the housing
- 27: flow channel
- 28: edge of the housing
- 30: power module

- A: stacking direction
- B: lateral direction of the insert / housing
- S(i): steps of a method for manufacturing a cooler unit

## Claims

1. A cooler unit (1) for liquid cooling of a power module (30), comprising:
- at least one insert (10) that comprises an upper part (15) and a lower part (16) and that is configured to be coupled to the power module (30) with the upper part (15), and
- a housing (20) that provides an internal flow channel (27) for a coolant and that comprises at least one recess (21) which penetrates a wall (25) of the housing (20) up to the flow channel (27) and which is configured in coordination with the at least one insert (10) geometrically, wherein the at least one insert (10) comprises copper and is arranged inside the recess (21) and laser welded to the housing (20) such that during operation the coolant flows through the flow channel (27) and around the lower part (16) of the at least one insert (10),
- wherein the at least one insert (10) and the housing (20) each comprises a respective welding area (14, 24), wherein the welding area (14) of the at least one insert (10) is formed at an edge (13) of the insert (10) and the welding area (24) of the housing (20) is formed at an edge (28) of the housing (20) limiting the at least one recess (21) such that a welding joint is formed by means of laser welding in the welding areas (14, 24) at a sidewall (17) of the insert (10) in part at least, and
- wherein the upper part (15) of the insert (10) comprises a topside (11) with a given surface structure including at least one of recessed portions and elevated parts facing away from the flow channel (27) that is configured to provide predetermined coupling properties for coupling the cooler unit (1) to the power module (30).

2. The cooler unit (1) according to claim 1, wherein the housing (20) comprises aluminum.

3. The cooler unit (1) according to any one of the preceding claims, wherein the at least one insert (10) comprises at least one coating that partially or completely covers at least one of the upper part (15) and the lower part (16) of the insert (10).

4. The cooler unit (1) according to claim 3, wherein the at least one coating comprises nickel and covers the lower part (16) of the insert (10).

5. The cooler unit (1) according to claim 3 or 4, wherein the at least one coating comprises silver and covers the upper part (15) of the insert (10).

6. The cooler unit (1) according to any one of the preceding claims, wherein the lower part (16) of the insert (10) comprises an underside (12) with a given surface structure facing the flow channel (27) that is configured to provide a given flow of the coolant and a given heat exchange surface between insert and coolant.

7. The cooler unit (1) according to claim 6, wherein the given structure comprises at least one of a pin-fin area, ribs and a skived structure and meander channels.

8. The cooler unit (1) according to any one of the preceding claims, wherein the housing (20) comprises an inlet (22) and an outlet (23) defining a flow direction of the coolant during operation, and wherein the housing (20) comprises two or more recesses (21) configured to accommodate a respective insert, wherein the at least one insert (10) comprising copper is arranged in one of the recesses (21) that is closer to the outlet (23) than the inlet (22) of the housing (20).

9. The cooler unit (1) according to any one of the preceding claims, wherein the cooler unit (1) comprises three inserts (10) each comprising copper and the housing (20) comprises three recesses (21) each penetrating the wall (25) of the housing (20) up to the flow channel (27) and each are configured in coordination with the associated insert (10) geometrically, wherein the inserts (10) are arranged inside the respective associated recess (21) and each laser welded to the housing (20).

10. A semiconductor device, comprising:
- a cooler unit (1) according to any one of the preceding claims, and
- a power module (30) with electronics, that is coupled to the upper part (15) of the insert (10) of the cooler unit (1).

11. The semiconductor device according to claim 10, wherein the insert (10) and the power module (30) are coupled with each other by means of at least one of gluing, sintering, soldering and bonding.

12. A method for manufacturing a cooler unit (1) for liquid cooling of a power module (30), comprising:
- providing at least one insert (10) that comprises an upper part (15) and a lower part (16) and that is configured to be coupled to the power module (30) with the upper part (15), and wherein the at least one insert (10) comprises copper,
- providing a housing (20) that provides an internal flow channel (27) for a coolant and that comprises at least one recess (21) which penetrates a wall (25) of the housing (20) up to the flow channel (27) and which is configured in coordination with the at least one insert (10) geometrically, wherein the at least one insert (10) and the housing (20) each comprises a respective welding area (14, 24), wherein the welding area (14) of the at least one insert (10) is formed at an edge (13) of the insert (10) and the welding area (24) of the housing (20) is formed at an edge (28) of the housing (20) limiting the at least one recess (21), and wherein the upper part (15) of the insert (10) comprises a topside (11) with a given surface structure including at least one of recessed portions and elevated parts facing away from the flow channel (27) that is configured to provide predetermined coupling properties for coupling the cooler unit (1) to the power module (30),
- placing the at least one insert (10) inside the recess (21) such that the at least one insert (10) contacts the housing (20), and
- laser welding the at least one insert (10) and the housing (20) together such that a welding joint is formed in the welding areas (14, 24) at a sidewall (17) of the insert (10) in part at least and such that during operation the coolant flows through the flow channel (27) and around the lower part (16) of the at least one insert (10).

## Patentansprüche

1. Kühleinheit (1) zur Flüssigkeitskühlung eines Leistungsmoduls (30), umfassend:
- mindestens einen Einsatz (10), der einen oberen Teil (15) und einen unteren Teil (16) umfasst und so konfiguriert ist, dass er mit dem oberen Teil (15) an das Leistungsmodul (30) gekoppelt werden kann, und
- ein Gehäuse (20), das einen internen Strömungskanal (27) für ein Kühlmittel bereitstellt und mindestens eine Aussparung (21) umfasst, die eine Wand (25) des Gehäuses (20) bis zum Strömungskanal (27) durchdringt und geometrisch auf den mindestens einen Einsatz (10) abgestimmt ist, wobei der mindestens eine Einsatz (10) Kupfer umfasst und innerhalb der Aussparung (21) angeordnet und mit dem Gehäuse (20) laserverschweißt ist, so dass während des Betriebs das Kühlmittel durch den Strömungskanal (27) und um den unteren Teil (16) des mindestens einen Einsatzes (10) herum strömt,
- wobei der mindestens eine Einsatz (10) und das Gehäuse (20) jeweils einen jeweiligen Schweißbereich (14, 24) umfassen, wobei der Schweißbereich (14) des mindestens einen Einsatzes (10) an einem Rand (13) des Einsatzes (10) ausgebildet ist und der Schweißbereich (24) des Gehäuses (20) an einem Rand (28) des Gehäuses (20) ausgebildet ist, der die mindestens eine Aussparung (21) begrenzt, so dass mittels Laserschweißen in den Schweißbereichen (14, 24) an einer Seitenwand (17) des Einsatzes (10) zumindest teilweise eine Schweißverbindung gebildet wird, und
- wobei der obere Teil (15) des Einsatzes (10) eine Oberseite (11) mit einer bestimmten Oberflächenstruktur umfasst, die vertiefte Abschnitte und/oder erhöhte Teile umfasst, die vom Strömungskanal (27) wegweisen, und so konfiguriert ist, dass sie vorbestimmte Kopplungseigenschaften zum Koppeln der Kühleinheit (1) mit dem Leistungsmodul (30) bereitstellt.

2. Kühleinheit (1) nach Anspruch 1, wobei das Gehäuse (20) Aluminium umfasst.

3. Kühleinheit (1) nach einem der vorhergehenden Ansprüche, wobei der mindestens eine Einsatz (10) mindestens eine Beschichtung umfasst, die den oberen Teil (15) und/oder den unteren Teil (16) des Einsatzes (10) teilweise oder vollständig bedeckt.

4. Kühleinheit (1) nach Anspruch 3, wobei die mindestens eine Beschichtung Nickel umfasst und den unteren Teil (16) des Einsatzes (10) bedeckt.

5. Kühleinheit (1) nach Anspruch 3 oder 4, wobei die mindestens eine Beschichtung Silber umfasst und den oberen Teil (15) des Einsatzes (10) bedeckt.

6. Kühleinheit (1) nach einem der vorhergehenden Ansprüche, wobei der untere Teil (16) des Einsatzes (10) eine Unterseite (12) mit einer bestimmten Oberflächenstruktur umfasst, die dem Strömungskanal (27) zugewandt ist und so konfiguriert ist, dass sie eine bestimmte Strömung des Kühlmittels und eine bestimmte Wärmeaustauschfläche zwischen Einsatz und Kühlmittel gewährleistet.

7. Kühleinheit (1) nach Anspruch 6, wobei die bestimmte Struktur einen Stiftrippenbereich und/oder Rippen und/oder eine geriffelte Struktur sowie Mäanderkanäle umfasst.

8. Kühleinheit (1) nach einem der vorhergehenden Ansprüche, wobei das Gehäuse (20) einen Einlass (22) und einen Auslass (23) umfasst, die eine Strömungsrichtung des Kühlmittels während des Betriebs definieren, und wobei das Gehäuse (20) zwei oder mehr Aussparungen (21) umfasst, die so konfiguriert sind, dass sie jeweils einen Einsatz aufnehmen können, wobei der mindestens eine Einsatz (10), der Kupfer umfasst, in einer der Aussparungen (21) angeordnet ist, die näher am Auslass (23) als am Einlass (22) des Gehäuses (20) liegt.

9. Kühleinheit (1) nach einem der vorhergehenden Ansprüche, wobei die Kühleinheit (1) drei Einsätze (10) umfasst, die jeweils Kupfer umfassen, und das Gehäuse (20) drei Aussparungen (21) umfasst, die jeweils die Wand (25) des Gehäuses (20) bis zum Strömungskanal (27) durchdringen und jeweils geometrisch auf den zugehörigen Einsatz (10) abgestimmt sind, wobei die Einsätze (10) innerhalb der jeweiligen zugehörigen Aussparung (21) angeordnet und jeweils mit dem Gehäuse (20) laserverschweißt sind.

10. Halbleitervorrichtung, umfassend:
- eine Kühleinheit (1) nach einem der vorhergehenden Ansprüche und
- ein Leistungsmodul (30) mit Elektronik, das mit dem oberen Teil (15) des Einsatzes (10) der Kühleinheit (1) gekoppelt ist.

11. Halbleitervorrichtung nach Anspruch 10, wobei der Einsatz (10) und das Leistungsmodul (30) durch Kleben und/oder Sintern und/oder Löten und/oder Bonden miteinander gekoppelt sind.

12. Verfahren zum Herstellen einer Kühleinheit (1) zur Flüssigkeitskühlung eines Leistungsmoduls (30), umfassend:
- Bereitstellen mindestens eines Einsatzes (10), der einen oberen Teil (15) und einen unteren Teil (16) umfasst und so konfiguriert ist, dass er mit dem oberen Teil (15) an das Leistungsmodul (30) gekoppelt werden kann, und wobei der mindestens eine Einsatz (10) Kupfer umfasst,
- Bereitstellen eines Gehäuses (20), das einen inneren Strömungskanal (27) für ein Kühlmittel bereitstellt und mindestens eine Aussparung (21) umfasst, die eine Wand (25) des Gehäuses (20) bis zum Strömungskanal (27) durchdringt und geometrisch auf den mindestens einen Einsatz (10) abgestimmt ist, wobei der mindestens eine Einsatz (10) und das Gehäuse (20) jeweils einen jeweiligen Schweißbereich (14, 24) umfassen, wobei der Schweißbereich (14) des mindestens einen Einsatzes (10) an einem Rand (13) des Einsatzes (10) und der Schweißbereich (24) des Gehäuses (20) an einem die mindestens eine Aussparung (21) begrenzenden Rand (28) des Gehäuses (20) ausgebildet ist , und wobei der obere Teil (15) des Einsatzes (10) eine Oberseite (11) mit einer bestimmten Oberflächenstruktur umfasst, die vertiefte Abschnitte und/oder erhöhte Teile umfasst, die vom Strömungskanal (27) wegweisen, und die so konfiguriert ist, dass sie vorbestimmte Kopplungseigenschaften zum Koppeln der Kühleinheit (1) mit dem Leistungsmodul (30) bereitstellt,
- Platzieren des mindestens einen Einsatzes (10) innerhalb der Aussparung (21), so dass der mindestens eine Einsatz (10) das Gehäuse (20) kontaktiert, und
- Laserverschweißen des mindestens einen Einsatzes (10) und des Gehäuses (20), so dass eine Schweißverbindung in den Schweißbereichen (14, 24) zumindest teilweise an einer Seitenwand (17) des Einsatzes (10) gebildet wird, und so dass während des Betriebs das Kühlmittel durch den Strömungskanal (27) und um den unteren Teil (16) des mindestens einen Einsatzes (10) herum strömt.

## Revendications

1. Unité de refroidisseur (1) pour le refroidissement par liquide d'un module de puissance (30), comprenant :
- au moins un insert (10) qui comprend une partie supérieure (15) et une partie inférieure (16) et qui est configuré pour être couplé au module de puissance (30) avec la partie supérieure (15), et
- un logement (20) qui fournit un canal d'écoulement (27) interne pour un liquide de refroidissement et qui comprend au moins un évidement (21) qui pénètre dans une paroi (25) du logement (20) jusqu'au canal d'écoulement (27) et qui est configuré en coordination avec l'au moins un insert (10) géométriquement, dans laquelle l'au moins un insert (10) comprend du cuivre et est agencé à l'intérieur de l'évidement (21) et soudé par laser au logement (20) de telle sorte que pendant le fonctionnement le liquide de refroidissement s'écoule à travers le canal d'écoulement (27) et autour de la partie inférieure (16) de l'au moins un insert (10),
- dans laquelle l'au moins un insert (10) et le logement (20) comprennent chacun une zone de soudage (14, 24) respective, dans laquelle la zone de soudage (14) de l'au moins un insert (10) est formée au niveau d'un bord (13) de l'insert (10) et la zone de soudage (24) du logement (20) est formée au niveau d'un bord (28) du logement (20) limitant l'au moins un évidement (21) de telle sorte qu'un joint de soudage est formé au moyen d'un soudage laser dans les zones de soudage (14, 24) au niveau d'une paroi latérale (17) de l'insert (10) en partie au moins, et
- dans laquelle la partie supérieure (15) de l'insert (10) comprend un côté de dessus (11) avec une structure de surface donnée incluant au moins un élément parmi des portions évidées et des parties élevées faisant face à l'opposé du canal d'écoulement (27) qui est configuré pour fournir des propriétés de couplage prédéterminées afin de coupler l'unité de refroidisseur (1) au module de puissance (30).

2. Unité de refroidisseur (1) selon la revendication 1, dans laquelle le logement (20) comprend de l'aluminium.

3. Unité de refroidisseur (1) selon l'une quelconque des revendications précédentes, dans laquelle l'au moins un insert (10) comprend au moins un revêtement qui couvre partiellement ou complètement au moins une partie parmi la partie supérieure (15) et la partie inférieure (16) de l'insert (10).

4. Unité de refroidisseur (1) selon la revendication 3, dans laquelle l'au moins un revêtement comprend du nickel et couvre la partie inférieure (16) de l'insert (10).

5. Unité de refroidisseur (1) selon la revendication 3 ou la revendication 4, dans laquelle l'au moins un revêtement comprend de l'argent et couvre la partie supérieure (15) de l'insert (10).

6. Unité de refroidisseur (1) selon l'une quelconque des revendications précédentes, dans laquelle la partie inférieure (16) de l'insert (10) comprend un côté de dessous (12) avec une structure de surface donnée faisant face au canal d'écoulement (27) qui est configuré pour fournir un écoulement donné du liquide de refroidissement et une surface d'échange de chaleur donnée entre l'insert et le liquide de refroidissement.

7. Unité de refroidisseur (1) selon la revendication 6, dans laquelle la structure donnée comprend au moins un élément parmi une zone de broches-ailettes, des nervures et une structure en biseau et des canaux en méandres.

8. Unité de refroidisseur (1) selon l'une quelconque des revendications précédentes, dans laquelle le logement (20) comprend une entrée (22) et une sortie (23) définissant une direction d'écoulement du liquide de refroidissement pendant le fonctionnement, et dans laquelle le logement (20) comprend deux évidements (21) ou plus configurés pour héberger un insert respectif, dans laquelle l'au moins un insert (10) comprend du cuivre est agencé dans l'un des évidements (21) qui est plus proche de la sortie (23) que de l'entrée (22) du logement (20).

9. Unité de refroidisseur (1) selon l'une quelconque des revendications précédentes, l'unité de refroidisseur (1) comprenant trois inserts (10) comprenant chacun du cuivre et le logement (20) comprend trois évidements (21) pénétrant chacun dans la paroi (25) du logement (20) jusqu'au canal d'écoulement (27) et chacun est configuré en coordination avec l'insert (10) associé géométriquement, dans laquelle les inserts (10) sont agencés à l'intérieur de l'évidement (21) associé respectif et chacun soudé par laser au logement (20).

10. Dispositif à semi-conducteur, comprenant :
- une unité de refroidissement (1) selon l'une quelconque des revendications précédentes, et
- un module de puissance (30) avec de l'électronique, qui est couplé à la partie supérieure (15) de l'insert (10) de l'unité de refroidisseur (1).

11. Dispositif à semi-conducteur selon la revendication 10, dans lequel l'insert (10) et le module de puissance (30) sont couplés l'un à l'autre au moyen d'au moins un processus parmi le collage, le frittage, le brasage et la liaison.

12. Procédé de fabrication d'une unité de refroidisseur (1) pour le refroidissement par liquide d'un module de puissance (30), comprenant :
- la fourniture d'au moins un insert (10) qui comprend une partie supérieure (15) et une partie inférieure (16) et qui est configuré pour être couplé au module de puissance (30) avec la partie supérieure (15), et dans lequel l'au moins un insert (10) comprend du cuivre,
- la fourniture d'un logement (20) qui fournit un canal d'écoulement (27) interne pour un liquide de refroidissement et qui comprend au moins un évidement (21) qui pénètre dans une paroi (25) du logement (20) jusqu'au canal d'écoulement (27) et qui est configuré en coordination avec l'au moins un insert (10) géométriquement, dans lequel l'au moins un insert (10) et le logement (20) comprennent chacun une zone de soudage (14, 24) respective, dans lequel la zone de soudage (14) de l'au moins un insert (10) est formée au niveau d'un bord (13) de l'insert (10) et la zone de soudage (24) du logement (20) est formée au niveau d'un bord (28) du logement (20) limitant l'au moins un évidement (21), et dans lequel la partie supérieure (15) de l'insert (10) comprend un côté de dessus (11) avec une structure de surface donnée incluant au moins un élément parmi des portions évidées et des parties élevées faisant face à l'opposé du canal d'écoulement (27) qui est configuré pour fournir des propriétés de couplage prédéterminées afin de coupler l'unité de refroidisseur (1) au module de puissance (30),
- le placement de l'au moins un insert (10) à l'intérieur de l'évidement (21) de telle sorte que l'au moins un insert (10) est en contact avec le logement (20), et
- le soudage laser de l'au moins un insert (10) et le logement (20) ensemble de telle sorte qu'un joint de soudage est formé dans les zones de soudage (14, 24) au niveau d'une paroi latérale (17) de l'insert (10) en partie au moins et de telle sorte que pendant le fonctionnement le liquide de refroidissement s'écoule à travers le canal d'écoulement (27) et autour de la partie inférieure (16) de l'au moins un insert (10).
